# FASCICULE DE BREVET EUROPEEN

(11) **EP 0 691 743 B1**
(45) Date de publication et mention de la délivrance du brevet: **27.12.2000**
(21) Numéro de dépôt: 95401603.6
(22) Date de dépôt: 04.07.1995
(51) Int. Cl.: H03K 17/96

(54) **Dispositif et clavier de commande à touche sensitive**
Berührungsempfindliche Einrichtung und Bedienungstastatur
Touch-sensitive device and control keyboard

(30) Priorité: 08.07.1994 FR 9408475
(43) Date de publication de la demande: 10.01.1996
(73) Titulaire: COMPAGNIE EUROPEENNE POUR L'EQUIPEMENT MENAGER "CEPEM", F-45140 St Jean-de-la-Ruelle (FR)
(72) Inventeur: Boultareau, Bernard, c/o Thomson-CSF SCPI, 92402 Courbevoie Cedex (FR); Houdou, Michel, c/o Thomson-CSF SCPI, 92402 Courbevoie Cedex (FR); Morineau, Jacques, c/o Thomson-CSF SCPI, 92402 Courbevoie Cedex (FR)
(74) Mandataire: Benoit, Monique

(56) Documents cités:
- EP-A- 0 017 318
- EP-A- 0 262 909
- DE-B- 2 630 944
- FR-A- 2 661 575

## Description

La présente invention concerne un dispositif et un clavier de commande à touche sensitive, et notamment à touches à effet capacitif, dont l'activation ne nécessite aucun déplacement mécanique de pièces.

De nombreux dispositifs à touche à effet capacitif ont été proposés, pour lesquels l'activation de la touche résulte de la modification d'une capacité, soit par contact direct du doigt d'un utilisateur sur l'une des armatures d'un condensateur constitué par dépôt de couches métallisées de part et d'autre d'un diélectrique, par exemple d'une plaque de circuit imprimé, soit en plaçant le doigt sur la face supérieure d'un support isolant, en regard d'une zone métallisée située sous le support, le doigt et la zone métallisée constituant alors les deux armatures d'un condensateur.

Dans les dispositifs connus, la touche est montée en dérivation sur l'entrée d'un circuit électronique de détection de l'activation de la touche, alimenté par un signal d'entrée en amont de la touche, et dont le rôle est de détecter la baisse de l'amplitude du signal électrique en aval de la touche lorsque celle-ci est activée. Pour ce faire, le circuit électronique comporte généralement des moyens de redressement du signal en aval de la touche, générant une tension continue redressée, et des moyens de comparaison de la tension continue redressée avec une tension continue de référence, constituant le seuil d'activation de la touche. Ces moyens de comparaison, généralement constitués d'un comparateur de tension à deux entrées ou d'un trigger de Schmitt, délivrent un signal de sortie à deux états représentatifs de l'activation ou de la non-activation de la touche, aptes à commander de nombreux types de circuits.

Dans la plupart des dispositifs connus, la tension de référence est fixe. Pour pouvoir tenir compte de certaines perturbations dues à l'environnement dans lequel est placée la touche, certains dispositifs prévoient une tension de référence flottante, obtenue à partir de la tension continue redressée et variant en fonction des variations lentes de cette tension, de manière à ce que le circuit de détection ne réagisse qu'à une variation rapide due à l'actionnement effectif de la touche. Un tel dispositif est par exemple décrit dans le document FR 2.661.575.

Le principal inconvénient de ce type de dispositifs de commande est qu'il nécessite la génération d'un signal d'entrée sinusoïdal à haute fréquence, typiquement de 800 KHz, ce qui oblige à augmenter l'amplitude en valeur crête du signal d'entrée par utilisation d'un amplificateur de tension accordé sur le fondamental d'un oscillateur. Un signal sinusoïdal de 800 KHz et de niveau élevé se superposant sur la fréquence de 50 Hz du secteur, on génère des perturbations conduites sur le secteur. Par ailleurs, l'amplificateur de tension, destiné à délivrer au circuit électronique un signal d'entrée bien supérieur à la tension d'alimentation de la touche pour augmenter la sensibilité de la touche, comprend en général un transformateur à noyau mobile pour le réglage de l'accord. Ce transformateur vient grever le coût total d'un dispositif de commande. De plus, l'accord est sensible à l'environnement.

Les documents EP-A-017 318 et DE- A- 2630 944 décrivent deux dispositifs commandés par touches capacitives. Les touches de ces deux dispositifs sont montées en dérivation sur l'entrée d'un circuit électronique de détection comportant un transistor bipolaire NPN. Le circuit électronique est, dans les deux dispositifs, excité par un signal d'entrée sous formes d'impulsions carrées polarisées positivement.

Le but principal de la présente invention est de proposer un dispositif de commande à touche sensitive qui ne présente pas les inconvénients mentionnés précédemment.

Plus précisément, selon un premier aspect, l'invention a pour objet un dispositif de commande à touche sensitive selon la revendication 1.

Selon un deuxième, troisième et quatrième aspect, l'invention a pour objet un dispositif de commande à touche sensitive selon la revendication 2, 9 et 10, respectivement.
Les impulsions sont polarisées de manière à ce que le transistor soit bloqué au repos, et devienne passant lors de l'activation de la touche.

Par ailleurs, la présente invention a également pour objet un clavier de commande comportant une pluralité de dispositifs de commande tels que définis ci-dessus, caractérisé en ce qu'un unique circuit d'alimentation délivre ledit signal d'entrée en parallèle à une pluralité de circuits électroniques.

L'invention, ainsi que les avantages qu'elle procure, seront mieux compris au vu de la description suivante faite en référence à la figure unique annexée, laquelle illustre, sous forme de synoptique simplifié, un mode de réalisation possible d'un clavier comportant plusieurs dispositifs de commande à touche selon l'invention.

Sur la figure, on a représenté, sous forme de synoptique simplifié, un clavier de commande comportant deux dispositifs à touche sensitive selon l'invention, le nombre de touches n'étant bien évidemment pas limité aux exemples représentés.

Chaque dispositif de commande comporte au moins une touche S et un circuit électronique de commande 1 à l'entrée duquel est montée la touche S en dérivation. Le circuit 1 est connecté en amont de la touche S par la sortie d'un circuit d'alimentation 2, et comporte des moyens de détection 10, 11 et 12 de l'activation de la touche par un utilisateur. La partie touche S du dispositif peut être réalisée de différentes façons, du moment qu'elle se comporte comme un condensateur en parallèle entre l'entrée du circuit et la masse :

Il peut par exemple s'agir d'un condensateur dont le diélectrique est formé par une plaquette de circuit imprimé sur les faces duquel on vient déposer des couches métallisées en vis-à-vis, l'une des couches étant reliée à l'entrée du circuit électronique, et l'autre couche étant la zone que l'utilisateur doit contacter. De manière avantageuse, la plaquette de circuit imprimé utilisée comme diélectrique sert également à supporter, partiellement ou en totalité, le reste du dispositif et de l'alimentation.

Une autre possibilité, représentée schématiquement sur la figure, consiste à placer la surface active Sₐ de la touche S sous une plaque V de verre, de vitrocéramique ou de tout autre matériau isolant formant un diélectrique, la surface active Sₐ constituant alors l'une des armatures d'un condensateur fictif, connectée électriquement à l'entrée du circuit de détection, l'autre armature étant constituée par le doigt d'un utilisateur posé sur le verre ou la vitrocéramique V, en regard avec la surface active Sₐ. La surface active peut être déposée sur la face supérieure ou inférieure d'un circuit imprimé placé derrière le verre ou la vitrocéramique. Cependant, pour être bien sûr qu'il n'y ait pas d'air entre les armatures du condensateur, la surface active de la touche est de préférence collée ou sérigraphiée directement sur la face inférieure de la plaque d'isolant V. La connexion électrique entre la surface électrique et les circuits de détection et d'alimentation est réalisée par tous moyens, par exemple par ressort métallisé ou par fils électriques.

Selon l'invention, le signal d'entrée I alimentant le circuit électrique 1 est constitué d'une succession d'impulsions polarisées, et les moyens de détection comportent d'une part, des moyens 10 générateurs de courant recevant le signal d'entrée I et délivrant un courant fonction de l'atténuation et de la déformation de chaque impulsion, lors de l'activation de la touche, et d'autre part, des moyens 12 de transformation du courant en une tension de commande V₀.

Dans le mode de réalisation préféré du dispositif selon l'invention, les moyens 10 générateurs de courant sont constitués essentiellement d'un transistor bipolaire T₁ excité simultanément sur sa base B₁ et sur son émetteur E₁, par le signal d'entrée I, par l'intermédiaire respectivement d'une résistance de base R₂ et d'une résistance d'émetteur R₁, la base B₁ étant également reliée électriquement à la surface active Sₐ de la touche.

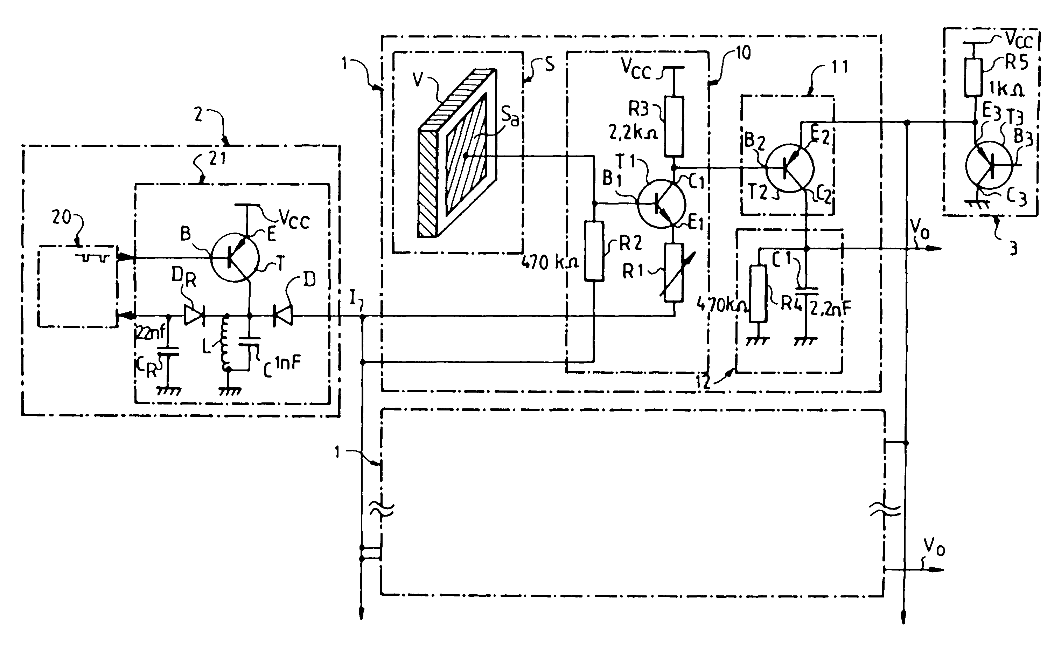

Les impulsions sont polarisées de manière à ce qu'au repos, c'est-à-dire lorsque la touche n'est pas activée, le transistor bipolaire T₁ soit à l'état bloqué. Dans l'exemple non limitatif de la figure 1, le transistor bipolaire T₁ est du type NPN, de sorte que les impulsions d'entrée doivent être négatives. Lorsqu'un utilisateur pose le doigt sur la touche, la capacité ainsi créée retarde et atténue notablement le signal sur la base B₁ alors que le signal sur l'émetteur E₁ n'est pas modifié. L'atténuation est notamment suffisante pour rendre le transistor bipolaire conducteur. Le courant de collecteur ainsi généré dépend de la surface en regard de la touche, et de l'amplitude des impulsions en entrée. Ce courant peut être avantageusement amplifié, par exemple par l'intermédiaire d'un second transistor bipolaire T₂ de type inverse par rapport au transistor T₁, c'est-à-dire de type PNP dans l'exemple de la figure. La base B₂ du transistor T₂ est connectée au collecteur C₁ du transistor T₁ pour recevoir le courant collecteur, et le courant amplifié est obtenu sur le collecteur C₂ du transistor T₂.

Les moyens de transformation du courant (amplifié ou non) en une tension sont de préférence constitués d'une cellule mémoire 12 comportant en parallèle un condensateur de stockage C₁ et une résistance R₄. Lorsque la touche n'est pas actionnée, le condensateur C₁ est déchargé par la résistance. Si la touche est activée, le courant généré charge le condensateur de stockage, lequel possède à ses bornes une tension de commande V₀ qui peut commander le basculement d'un interrupteur analogique non représenté. La cellule mémoire possède une constante de temps 1/R₄C₁ suffisamment grande devant la période du signal d'entrée, par exemple de 1 ms lorsque la fréquence du signal d'entrée est de l'ordre de 50 KHz. Chaque impulsion est de préférence une arche de sinusoïde. Une succession d'arches de sinusoïde est par exemple obtenue, comme représenté sur la figure, par l'intermédiaire du circuit d'alimentation 2 suivant :

Un astable 20 de réalisation connu en soi, délivre à un oscillateur 21, une succession d'impulsions rectangulaires, polarisées positivement, avec un faible rapport cyclique et une fréquence de quelques dizaines de KHz. L'oscillateur 21 comprend un transistor bipolaire T, de type PNP, dont la base B reçoit la succession d'impulsions issues de l'astable 20, et l'émetteur E est relié à une tension d'alimentation V_{CC}, par exemple de 5,2 volts. Le collecteur C du transistor T est relié à la masse par l'intermédiaire d'une inductance L en parallèle avec un condensateur C. A chaque niveau bas des impulsions issues de l'astable 20, le transistor T conduit et charge l'inductance L. L'énergie ainsi accumulée dans L est ensuite transférée dans le condensateur C, au moment du blocage du transistor T. Une diode D dont la cathode est reliée électriquement au condensateur C permet de prélever une succession d'arches de sinusoïde négatives dont l'amplitude dépend du temps de conduction du transistor T. De la même manière que précédemment, un oscillateur comportant un transistor NPN et des diodes inversées permettra d'obtenir une succession d'arches positives à envoyer simultanément sur la base et sur l'émetteur d'un transistor de type PNP.

Les valeurs des composantes reportées sur la figure à titre d'exemple non limitatif, permettent de générer une succession d'arches de sinusoïde négatives de fréquence égale à 250 KHz et d'amplitude égale à -17 volts.

L'utilisation d'un astable 20 à faible rapport cyclique avec une fréquence de quelques dizaines de KHz a pour avantage de réduire l'énergie rayonnante nécessaire.

Certaines améliorations avantageuses du dispositif à touche sensitive selon l'invention peuvent être apportées :

Pour s'assurer que l'amplitude des arches de sinusoïde soit sensiblement constante, on peut utiliser, dans l'oscillateur 21, un filtre de redressement composé d'une diode D_{R} et d'un condensateur de régulation C_{R}, connectés en parallèle aux bornes de l'inductance L, comme illustré sur la figure. On obtient, aux bornes du condensateur C_{R}, une tension de régulation qui vient commander, de façon connue, le fonctionnement de l'astable, de manière à réguler le temps de conduction du transistor T.

Par ailleurs, la tension *V*_{*B*}₁_{*E*}₁ entre l'émetteur E₁ et la base B₁ du transistor T₁ est très sensible à la variation de température. Pour éviter un déclenchement intempestif de la touche ou une variation de la sensibilité de la touche, on peut avantageusement appliquer une tension de blocage, entre E₁ et B₁, supérieure à celle d'une jonction classique, par exemple de 1,2V au lieu de 0,6V.

Enfin, la référence de tension utilisée par l'amplificateur de courant 11 doit être très stable vis-à-vis des variations de la tension d'alimentation V_{CC}. Une compensation en température peut être réalisée par un dispositif de compensation 3 comprenant essentiellement un transistor T₃ de même type que le transistor T₂, dont l'émetteur E₃ est relié à l'émetteur E₂ du transistor T₂. Dans le cas d'un clavier comportant une pluralité de dispositifs à touche selon l'invention, un dispositif de compensation 3 unique permet avantageusement de compenser les amplificateurs de tous les dispositifs.

D'autre part, on a supposé dans ce qui précède que les transistors utilisés étaient bipolaires. Bien entendu, chaque transistor bipolaire peut être remplacé par un transistor à effet de champ de type N ou de type P, dont la grille et la source reçoivent simultanément les impulsions polarisées.

Les résistances de base, d'émetteur et de collecteur sont alors respectivement appelées résistances de grille, de source et de drain.

Les impulsions polarisées sont de préférence des arches de sinusoïde. Il n'est cependant pas exclu d'envisager d'autres formes d'impulsions (rectangulaires, triangulaires...).

L'avantage principal du dispositif de commande selon l'invention résulte de l'utilisation d'un signal d'entrée impulsionnel ; il n'est en effet pas nécessaire d'utiliser un transformateur, comme dans les dispositifs de l'art antérieur, et la consommation d'un dispositif selon l'invention est plus faible.

Par ailleurs, le fait d'alimenter simultanément la base et l'émetteur du transistor T₁ permet de ne pas avoir le déclenchement intempestif dû à des variations du signal d'entrée I.

Enfin, du fait de l'utilisation d'une cellule mémoire, les perturbations de courte durée au niveau de la touche ne sont pas prises en compte.

## Revendications

1. Dispositif de commande à touche sensitive du type comportant au moins une touche (S) à effet capacitif montée en dérivation sur l'entrée d'un circuit électronique (1) alimenté, en amont de la touche (S), par un signal d'entrée généré par un circuit d'alimentation (2), ledit signal d'entrée étant constitué d'une succession d'impulsions polarisées, ledit circuit électronique comprenant des moyens (10, 11, 12) de détection de l'activation de la touche, lesdits moyens de détection comportant des moyens (10) générateurs de courant excités par le signal impulsionnel d'entrée et délivrant, lors d'une activation de la touche, un courant fonction de l'atténuation et de la déformation de chaque impulsion du signal impulsionnel d'entrée dues à la manipulation de la touche (S) et des moyens (12) pour transformer ledit courant en une tension de commande (V₀), lesdits moyens (10) générateurs de courant comportant un transistor bipolaire (T₁) de type NPN dont la base (B₁) et l'émetteur (E₁) reçoivent simultanément les impulsions polarisées et dont le collecteur (C₁) est alimenté par une tension d'alimentation (V_{CC}) prédéterminée positive par rapport à la masse, la touche (S) étant connectée électriquement à la base (B₁) du transistor, les impulsions étant polarisées de façon à ce que le transistor bipolaire (T₁) soit passant seulement en cas d'activation de la touche, ledit dispositif étant caractérisé en ce que les implusions sont polarisées négativement par rapport à la masse.

2. Dispositif de commande à touche sensitive du type comportant au moins une touche (S) à effet capacitif montée en dérivation sur l'entrée d'un circuit électronique (1) alimenté, en amont de la touche (S), par un signal d'entrée généré par un circuit d'alimentation (2), ledit signal d'entrée étant constitué d'une succession d'impulsions polarisées, ledit circuit électronique comprenant des moyens (10, 11, 12) de détection de l'activation de la touche, lesdits moyens de détection comportant des moyens (10) générateurs de courant excités par le signal impulsionnel d'entrée et délivrant, lors d'une activation de la touche, un courant fonction de l'atténuation et de la déformation de chaque impulsion du signal impulsionnel d'entrée dues à la manipulation de la touche (S) et des moyens (12) pour transformer ledit courant en une tension de commande (V₀), lesdits moyens (10) générateurs de courant comportant un transistor bipolaire (T₁) dont la base (B₁) et l'émetteur (E₁) reçoivent simultanément les impulsions polarisées et dont le collecteur (C₁) est alimenté par une tension d'alimentation (V_{CC}) prédéterminée négative par rapport à la masse, la touche (S) étant connectée électriquement à la base (B₁) du transistor, les impulsions étant polarisées positivement par rapport à la masse de façon à ce que le transistor bipolaire (T₁) soit passant seulement en cas d'activation de la touche, ledit dispositif étant caractérisé en ce que le transistor bipolaire (T₁) est de type PNP.

3. Dispositif de commande selon l'une des revendications précédentes, caractérisé en ce que le transistor (T1) reçoit les impulsions polarisées par l'intermédiaire d'une résistance de base (R₂) et par l'intermédiaire d'une résistance d'émetteur (R₁).

4. Dispositif de commande selon la revendication 3, caractérisé en ce que la résistance d'émetteur (R₁) peut être ajustée de manière à régler la sensibilité de la touche (S).

5. Dispositif de commande selon l'une des revendications précédentes, caractérisé en ce que le transistor (T1) comporte un collecteur (C1) alimenté par une tension d'alimentation (V_{CC}) prédéterminée par l'intermédiaire d'une résistance de collecteur (R_{C}).

6. Dispositif de commande selon l'une quelconque des revendications précédentes, caractérisé en ce que les moyens de détection comportent en outre des moyens (11) d'amplification du courant délivré par les moyens générateurs de courant, placés en amont des moyens (12) de transformation du courant en tension de commande.

7. Dispositif de commande selon les revendications 1 et 6 en tant que revendication dépendante de la revendication 1, caractérisé en ce que lesdits moyens d'amplification sont constitués d'un transistor bipolaire (T₂) de type PNP dont la base (B₂) reçoit le courant issu des moyens générateurs de courant, et dont le collecteur (C₂) délivre un courant amplifié aux moyens de transformation du courant en tension de commande.

8. Dispositif de commande selon les revendications 2 et 6 en tant que revendication dépendante de la revendication 2, caractérisé en ce que lesdits moyens d'amplification sont constitués d'un transistor bipolaire de type NPN dont la base reçoit le courant issu des moyens générateurs de courant, et dont le collecteur délivre un courant amplifié aux moyens de transformation du courant en tension de commande.

9. Dispositif de commande à touche sensitive du type comportant au moins une touche (S) à effet capacitif montée en dérivation sur l'entrée d'un circuit électronique (1) alimenté, en amont de la touche (S), par un signal d'entrée généré par un circuit d'alimentation (2), ledit signal d'entrée étant constitué d'une succession d'impulsions polarisées, ledit circuit électronique comprenant des moyens (10, 11, 12) de détection de l'activation de la touche, lesdits moyens de détection comportant des moyens (10) générateurs de courant excités par le signal impulsionnel d'entrée et délivrant, lors d'une activation de la touche, un courant fonction de l'atténuation et de la déformation de chaque impulsion du signal impulsionnel d'entrée dues à la manipulation de la touche (S) et des moyens (12) pour transformer ledit courant en une tension de commande (V₀), ledit dispositif étant caractérisé en ce que lesdits moyens (10) générateurs de courant comportent un transistor à effet de champ de type N dont la grille et la source reçoivent simultanément les impulsions polarisées et dont le drain est alimenté par une tension d'alimentation (V_{CC}) prédéterminée positive par rapport à la masse, en ce que la touche (S) est connectée électriquement à la grille du transistor à effet de champ, et en ce que les impulsions sont polarisées négativement par rapport à la masse de façon à ce que le transistor à effet de champ soit passant seulement en cas d'activation de la touche.

10. Dispositif de commande à touche sensitive du type comportant au moins une touche (S) à effet capacitif montée en dérivation sur l'entrée d'un circuit électronique (1) alimenté, en amont de la touche (S), par un signal d'entrée généré par un circuit d'alimentation (2), ledit signal d'entrée étant constitué d'une succession d'impulsions polarisées, ledit circuit électronique comprenant des moyens (10, 11, 12) de détection de l'activation de la touche, lesdits moyens de détection comportant des moyens (10) générateurs de courant excités par le signal impulsionnel d'entrée et délivrant, lors d'une activation de la touche, un courant fonction de l'atténuation et de la déformation de chaque impulsion du signal impulsionnel d'entrée dues à la manipulation de la touche (S) et des moyens (12) pour transformer ledit courant en une tension de commande (V₀), ledit dispositif étant caractérisé en ce que lesdits moyens (10) générateurs de courant comportent un transistor à effet de champ de type P dont la grille et la source reçoivent simultanément les impulsions polarisées et dont le drain est alimenté par une tension d'alimentation (V_{CC}) prédéterminée négative par rapport à la masse, en ce que la touche (S) est connectée électriquement à la grille du transistor à effet de champ, et en ce que les impulsions sont polarisées positivement par rapport à la masse de façon à ce que le transistor à effet de champ soit passant seulement en cas d'activation de la touche.

11. Dispositif de commande selon l'une quelconque des revendications 9 et 10, caractérisé en ce que le transistor à effet de champ reçoit les impulsions sont polarisées sur sa grille et sur sa source respectivement par l'intermédiaire d'une résistance de grille et d'une résistance de source, en ce que le transistor à effet de champ comporte un drain alimenté par une tension d'alimentation (V_{CC}) prédéterminée, par l'intermédiaire d'une résistance de drain et en ce que la touche (S) est connectée électriquement entre la résistance de grille et la grille du transistor à effet de champ.

12. Dispositif de commande selon l'une quelconque des revendications précédentes, caractérisé en ce que les moyens (12) pour transformer ledit courant en une tension de commande sont constitués de la mise en parallèle d'une résistance (R4) et d'un condensateur de stockage (C₁).

13. Dispositif de commande selon l'une quelconque des revendications précédentes, caractérisé en ce que les impulsions polarisées sont des arches de sinusoïde.

14. Dispositif de commande selon la revendication 13, caractérisé en ce que le circuit d'alimentation (2) comporte un astable (20) délivrant à un oscillateur (21) une succession d'impulsions, l'oscillateur comprenant une inductance (L) chargée pendant la conduction d'un transistor (T), un condensateur (C) en parallèle avec l'inductance, et dans lequel ladite inductance (L) se décharge pendant le blocage dudit transistor, et une diode (D) prélevant lesdites impulsions polarisées.

15. Clavier de commande comportant une pluralité de dispositifs de commande selon l'une quelconque des revendications 1 à 14, caractérisé en ce qu'un unique circuit d'alimentation (2) délivre ledit signal d'entrée en parallèle à une pluralité de circuits électroniques (1).

## Patentansprüche

1. Steuervorrichtung mit Berührungstasten des Typs, der wenigstens eine Taste (S) mit kapazitiver Wirkung enthält, die parallel zum Eingang einer elektronischen Schaltung (1) geschaltet ist, die auf der Eingangsseite der Taste (S) mit einem Eingangssignal gespeist wird, das durch eine Versorgungsschaltung (2) erzeugt wird und aus einer Folge polarisierter Impulse gebildet ist, wobei die elektronische Schaltung Mittel (10, 11, 12) zur Erfassung der Aktivierung der Taste aufweist, die Stromgeneratormittel (10), die durch das Eingangsimpulssignal erregt werden und bei einer Aktivierung der Taste einen Strom liefern, der von der Dämpfung und von der Verformung jedes Impulses des Eingangsimpulssignals, die durch die Betätigung der Taste S bedingt sind, abhängt, sowie Mittel (12) zum Umwandeln des Stroms in eine Steuerspannung (V₀) enthalten, wobei die Stromgeneratormittel (10) einen Bipolartransistor (T₁) des Typs NPN enthalten, dessen Basis (B₁) und dessen Emitter (E₁) gleichzeitig die polarisierten Impulse empfangen und dessen Kollektor (C₁) durch eine in bezug auf Masse positive, vorgegebene Versorgungsspannung (V_{CC}) versorgt wird, wobei die Taste (S) mit der Basis (B₁) des Transistors elektrisch verbunden ist und die Impulse in der Weise polarisiert sind, daß der Bipolartransistor (T₁) nur bei Aktivierung der Taste durchschaltet, wobei die Vorrichtung dadurch gekennzeichnet ist, daß die Impulse in bezug auf Masse negativ polarisiert sind.

2. Steuervorrichtung mit Berührungstaste des Typs, der wenigstens eine Taste (S) mit kapazitiver Wirkung enthält, die parallel zum Eingang einer elektronischen Schaltung (1) geschaltet ist, die auf der Eingangsseite der Taste (S) durch ein Eingangssignal gespeist wird, das von einer Versorgungsschaltung (2) erzeugt wird und aus einer Folge polarisierter Impulse gebildet ist, wobei die elektronische Schaltung Mittel (10, 11, 12) zur Erfassung der Aktivierung der Taste aufweist, die Stromgeneratormittel (10), die durch das Eingangsimpulssignal erregt werden und bei einer Aktivierung der Taste einen Strom liefern, der von der Dämpfung und von der Verformung jedes Impulses des Eingangsimpulssignals, die durch die Betätigung der Taste (S) bedingt sind, abhängt, sowie Mittel (12) zum Umwandeln des Stroms in eine Steuerspannung (V₀) enthalten, wobei die Stromgeneratormittel (10) einen Bipolartransistor (T₁) enthalten, dessen Basis (B₁) und dessen Emitter (E₁) gleichzeitig die polarisierten Impulse empfangen und dessen Kollektor (C₁) mit einer in bezug auf Masse negativen vorgegebenen Versorgungsspannung (V_{CC}) versorgt wird, wobei die Taste mit der Basis (B₁) des Transistors elektrisch verbunden ist und die Impulse in bezug auf Masse positiv polarisiert sind, so daß der Bipolartransistor (T₁) nur bei Aktivierung der Taste durchschaltet, wobei die Vorrichtung dadurch gekennzeichnet ist, daß der Bipolartransistor (T₁) vom Typ PNP ist.

3. Steuervorrichtung nach einem der vorangehenden Ansprüche, dadurch gekennzeichnet, daß der Transistor (T₁) die polarisierten Impulse über einen Basiswiderstand (R₂) und über einen Emitterwiderstand (R₁) empfängt.

4. Steuervorrichtung nach Anspruch 3, dadurch gekennzeichnet, daß der Emitterwiderstand (R₁) in der Weise eingestellt werden kann, daß die Empfindlichkeit der Taste (S) gesteuert wird.

5. Steuervorrichtung nach einem der vorangehenden Ansprüche, dadurch gekennzeichnet, daß der Transistor (T₁) einen Kollektor (C₁) enthält, der über einen Kollektorwiderstand (R_{C}) mit einer vorgegebenen Versorgungsspannung (V_{CC}) versorgt wird.

6. Steuervorrichtung nach einem der vorangehenden Ansprüche, dadurch gekennzeichnet, daß die Erfassungsmittel außerdem Mittel (11) zum Verstärken des von den Stromgeneratormitteln gelieferten Stroms enthalten, die auf der Eingangsseite der Mittel (12) zum Umwandeln des Stroms in eine Steuerspannung angeordnet sind.

7. Steuervorrichtung nach den Ansprüchen 1 und 6 als von Anspruch abhängender Anspruch, dadurch gekennzeichnet, daß die Verstärkungsmittel aus einem Bipolartransistor (T₂) des Typs PNP gebildet sind, dessen Basis (B₂) den von den Stromgeneratormitteln ausgegebenen Strom empfängt und dessen Kollektor (C₂) einen verstärkten Strom an die Mittel zur Umwandlung des Stroms in eine Steuerspannung liefert.

8. Steuervorrichtung nach den Ansprüchen 2 und 6 als von Anspruch 2 abhängender Anspruch, dadurch gekennzeichnet, daß die Verstärkungsmittel aus einem Bipolartransistor des Typs NPN gebildet sind, dessen Basis den von den Stromgeneratormitteln gelieferten Strom empfängt und dessen Kollektor einen verstärkten Strom an die Mittel zur Umwandlung des Stroms in eine Steuerspannung liefert.

9. Steuervorrichtung mit Berührungstaste des Typs, der wenigstens eine Taste (S) mit kapazitiver Wirkung enthält, die parallel zum Eingang einer elektronischen Schaltung (1) geschaltet ist, die auf der Eingangsseite der Taste (S) mit einem Eingangssignal gespeist wird, das von einer Versorgungsschaltung (2) erzeugt wird und aus einer Folge polarisierter Impulse gebildet ist, wobei die elektronische Schaltung Mittel (10, 11, 12) zur Erfassung der Aktivierung der Taste aufweist, die Stromgeneratormittel (10), die durch das Eingangsimpulssignal erregt werden und bei einer Aktivierung der Taste einen Strom liefern, der von der Dämpfung und von der Verformung des Eingangsimpulssignals, die durch die Betätigung der Taste (S) bedingt sind, abhängt, sowie Mittel (12) zum Umwandeln des Stroms in eine Steuerspannung (V₀) enthalten, wobei die Vorrichtung dadurch gekennzeichnet ist, daß die Stromgeneratormittel (10) einen Feldeffekttransistor des Typs N enthalten, dessen Gate und dessen Source gleichzeitig die polarisierten Impulse empfangen und dessen Drain mit einer in bezug auf Masse positiven vorgegebenen Versorgungsspannung (V_{CC}) versorgt wird, daß die Taste (S) mit dem Gate des Feldeffekttransistors elektrisch verbunden ist und daß die Impulse in bezug auf Masse negativ polarisiert sind, so daß der Feldeffekttransistor nur bei einer Betätigung der Taste durchschaltet.

10. Steuervorrichtung mit Berührungstaste des Typs, der wenigstens eine Taste (S) mit kapazitiver Wirkung enthält, die parallel zum Eingang einer elektronischen Schaltung (1) geschaltet ist, die auf der Eingangsseite der Taste (S) mit einem Eingangssignal erzeugt wird, das von einer Versorgungsschaltung (2) erzeugt wird und aus einer Folge polarisierter Impulse gebildet ist, wobei die elektronische Schaltung Mittel (10, 11, 12) zur Erfassung der Betätigung der Taste aufweist, die Stromgeneratormittel (10), die durch das Eingangsimpulssignal erregt werden und bei einer Betätigung der Taste einen Strom liefern, der von der Dämpfung und von der Verformung jedes Impulses des Eingangsimpulssignals, die durch die Betätigung der Taste (S) bedingt sind, abhängt, sowie Mittel (12) zum Umwandeln des Stroms in eine Steuerspannung (V₀) enthalten, wobei die Vorrichtung dadurch gekennzeichnet ist, daß die Stromgeneratormittel (10) einen Feldeffekttransistor des Typs P enthalten, dessen Gate und dessen Source gleichzeitig die polarisierten Impulse empfangen und dessen Drain mit einer in bezug auf Masse negativen vorgegebenen Versorgungsspannung (V_{CC}) versorgt wird, daß die Taste (S) mit dem Gate des Feldeffekttransistors elektrisch verbunden ist und daß die Impulse in bezug auf Masse positiv polarisiert sind, so daß der Feldeffekttransistor nur bei Betätigung der Taste durchschaltet.

11. Steuervorrichtung nach einem der Ansprüche 9 und 10, dadurch gekennzeichnet, daß der Feldeffekttransistor die polarisierten Impulse an seinem Gate bzw. an seiner Source über einen Gatewiderstand bzw. einen Sourcewiderstand empfängt, daß der Feldeffekttransistor einen Drain enthält, der mit einer vorgegebenen Versorgungsspannung (V_{CC}) über einen Drainwiderstand versorgt wird, und daß die Taste (S) zwischen den Gatewiderstand und das Gate des Feldeffekttransistors elektrisch geschaltet ist.

12. Steuervorrichtung nach einem der vorangehenden Ansprüche, dadurch gekennzeichnet, daß die Mittel (12) zum Umwandeln des Stroms in eine Steuerspannung aus der Parallelschaltung eines Widerstandes (R4) und eines Speicherkondensators (C₁) gebildet sind.

13. Steuervorrichtung nach einem der vorangehenden Ansprüche, dadurch gekennzeichnet, daß die polarisierten Impulse sinusförmige Bögen sind.

14. Steuervorrichtung nach Anspruch 13, dadurch gekennzeichnet, daß die Versorgungsschaltung (2) ein astabiles Glied (20) enthält, das an einen Oszillator (21) eine Impulsfolge liefert, wobei der Oszillator eine Induktivität (L), die während des Durchschaltens eines Transistors (T) geladen wird, einen zur Induktivität parallelen Kondensator (C), in den sich die Induktivität (L) während der Sperrung des Transistors entlädt, sowie eine Diode (D), die die polarisierten Impulse entnimmt, enthält.

15. Steuertastatur, die mehrere Steuervorrichtungen nach einem der Ansprüche 1 bis 14 enthält, dadurch gekennzeichnet, daß eine einzige Versorgungsschaltung (2) das Eingangssignal parallel an mehrere elektronische Schaltungen (1) liefert.

## Claims

1. Control device with sensitive touchpad of the type comprising at least one capacitive-effect touchpad (S) branched off from the input of an electronic circuit (1) supplied, upstream of the touchpad (S), with an input signal generated by a supply circuit (2), the said input signal consisting of a succession of biased pulses, the said electronic circuit comprising means (10, 11, 12) of detection of the activation of the touchpad, the said means of detection comprising current-generator means (10) excited by the input pulse signal and delivering, during activation of the touchpad, a current which depends on the attenuation and on the deformation of each pulse of the input pulse signal which are due to the manipulating of the touchpad (S) and means (12) for transforming the said current into a control voltage (V₀), the said current-generator means (10) comprising a bipolar transistor (T₁) of NPN type whose base (B₁) and emitter (E₁) simultaneously receive the biased pulses, and whose collector (C₁) is supplied with a predetermined supply voltage (V_{CC}) which is positive with respect to earth, the touchpad (S) being connected electrically to the base (B₁) of the transistor, the pulses being biased in such a way that the bipolar transistor (T₁) is on only in the event of activation of the touchpad, the said device being characterized in that the pulses are biased negatively with respect to earth.

2. Control device with sensitive touchpad of the type comprising at least one capacitive-effect touchpad (S) branched off from the input of an electronic circuit (1) supplied, upstream of the touchpad (S), with an input signal generated by a supply circuit (2), the said input signal consisting of a succession of biased pulses, the said electronic circuit comprising means (10, 11, 12) of detection of the activation of the touchpad, the said means of detection comprising current-generator means (10) excited by the input pulse signal and delivering, during activation of the touchpad, a current which depends on the attenuation and on the deformation of each pulse of the input pulse signal which are due to the manipulating of the touchpad (S) and means (12) for transforming the said current into a control voltage (V₀), the said current-generator means (10) comprising a bipolar transistor (T₁) whose base (B₁) and emitter (E₁) simultaneously receive the biased pulses, and whose collector (C₁) is supplied with a predetermined supply voltage (V_{CC}) which is negative with respect to earth, the touchpad (S) being connected electrically to the base (B₁) of the transistor, the pulses being positively biased with respect to earth so that the bipolar transistor (T₁) is on only in the event of activation of the touchpad, the said device being characterized in that the bipolar transistor (T₁) is of PNP type.

3. Control device according to one of the preceding claims, characterized in that the transistor (T₁) receives the biased pulses by way of a base resistance (R₂) and by way of an emitter resistance (R₁).

4. Control device according to Claim 3, characterized in that the emitter resistance (R₁) can be tailored so as to adjust the sensitivity of the touchpad (S).

5. Control device according to one of the preceding claims, characterized in that the transistor (T₁) comprises a collector (C₁) supplied with a predetermined supply voltage (V_{CC}) by way of a collector resistance (R_{C}).

6. Control device according to any one of the preceding claims, characterized in that the detection means furthermore comprise means (11) for amplifying the current delivered by the current-generator means, placed upstream of the means (12) for transforming the current into control voltage.

7. Control device according to Claims 1 and 6 in the guise of claim dependent on Claim 1, characterized in that the said amplifying means consist of a bipolar transistor (T₂) of PNP type whose base (B₂) receives the current emanating from the current-generator means, and whose collector (C₂) delivers an amplified current to the means for transforming the current into control voltage.

8. Control device according to Claims 2 and 6 in the guise of claim dependent on Claim 2, characterized in that the said amplifying means consist of a bipolar transistor of NPN type whose base receives the current emanating from the current-generator means, and whose collector delivers an amplified current to the means for transforming the current into control voltage.

9. Control device with sensitive touchpad of the type comprising at least one capacitive-effect touchpad (S) branched off from the input of an electronic circuit (1) supplied, upstream of the touchpad (S), with an input signal generated by a supply circuit (2), the said input signal consisting of a succession of biased pulses, the said electronic circuit comprising means (10, 11, 12) of detection of the activation of the touchpad, the said means of detection comprising current-generator means (10) excited by the input pulse signal and delivering, during activation of the touchpad, a current which depends on the attenuation and on the deformation of each pulse of the input pulse signal which are due to the manipulating of the touchpad (S) and means (12) for transforming the said current into a control voltage (V₀), the said device being characterized in that the said current-generator means (10) comprise a field-effect transistor of N type whose gate and source simultaneously receive biased pulses, and whose drain is supplied with a predetermined supply voltage (V_{CC}) which is positive with respect to earth, and in that the touchpad (S) is connected electrically to the gate of the field-effect transistor, and in that the pulses are negatively biased with respect to earth so that the field-effect transistor is on only in the event of activation of the touchpad.

10. Control device with sensitive touchpad of the type comprising at least one capacitive-effect touchpad (S) branched off from the input of an electronic circuit (1) supplied, upstream of the touchpad (S), with an input signal generated by a supply circuit (2), the said input signal consisting of a succession of biased pulses, the said electronic circuit comprising means (10, 11, 12) of detection of the activation of the touchpad, the said means of detection comprising current-generator means (10) excited by the input pulse signal and delivering, during activation of the touchpad, a current which depends on the attenuation and on the deformation of each pulse of the input pulse signal which are due to the manipulating of the touchpad (S) and means (12) for transforming the said current into a control voltage (V₀), the said device being characterized in that the said current-generator means (10) comprise a field-effect transistor of P type whose gate and source simultaneously receive biased pulses, and whose drain is supplied with a predetermined supply voltage (V_{CC}) which is negative with respect to earth, in that the touchpad (S) is connected electrically to the gate of the field-effect transistor, and in that the pulses are positively biased with respect to earth so that the field-effect transistor is on only in the event of activation of the touchpad.

11. Control device according to either one of Claims 9 and 10, characterized in that the field-effect transistor receives the biased pulses on its gate and on its source respectively by way of a gate resistance and a source resistance, in that the field-effect transistor comprises a drain supplied with a predetermined supply voltage (V_{CC}), by way of a drain resistance and in that the touchpad (S) is connected electrically between the gate resistance and the gate of the field-effect transistor.

12. Control device according to any one of the preceding claims, characterized in that the means (12) for transforming the said current into a control voltage consist of the parallel arrangement of a resistor (R4) and of a storage capacitor (C₁).

13. Control device according to any one of the preceding claims, characterized in that the biased pulses are arcs of a sinusoid.

14. Control device according to Claim 3, characterized in that the supply circuit (2) comprises an astable (20) delivering a succession of pulses to an oscillator (21), the oscillator comprising an inductor (L) which is energized while a transistor (T) is on, a capacitor (C) in parallel with the inductor, and in which the said inductor (L) is de-energized while the said transistor is off, and a diode (D) tapping off the said biased pulses.

15. Control keypad comprising a plurality of control devices according to any one of Claims 1 to 14, characterized in that a single supply circuit (2) delivers the said input signal in parallel to a plurality of electronic circuits (1).
